# EUROPÄISCHE PATENTSCHRIFT

(11) **EP 0 347 717 B1**
(45) Veröffentlichungstag und Bekanntmachung des Hinweises auf die Patenterteilung: **14.09.1994**
(21) Anmeldenummer: 89110662.7
(22) Anmeldetag: 13.06.1989
(51) Int. Cl.: H05H 1/00, H01J 37/32

(54) **Schaltungsanordnung zum Erkennen eines Plasmas**
Circuit for determining the presence of a plasma
Circuit de vérification de l'existence d'un plasma

(30) Priorität: 23.06.1988 DE 3821208
(43) Veröffentlichungstag der Anmeldung: 27.12.1989
(73) Patentinhaber: LEYBOLD AKTIENGESELLSCHAFT, D-63450 Hanau (DE)
(72) Erfinder: Gesche, Roland, Dr., D-6453 Seligenstadt (DE); Vey, Norbert, D-6466 Mittel-Gründau (DE)
(74) Vertreter: Schickedanz, Willi, Dipl.-Ing.

(56) Entgegenhaltungen:
- US-A- 4 207 137
- US-A- 4 493 112
- Journal of physics E: scientific instruments; Band 7, No 7, August 1974 (8. 1974) seiten 537-538 D. HONEA et al.: "Improved construction of Rogowski coils for measurement of plasma currents"

## Beschreibung

Die Erfindung betrifft ein Verfahren nach dem Oberbegriff des Patentanspruchs 1 und ein Mittel nach dem Oberbegriff des Patentanspruchs 2.

Mit Hilfe von Plasmen werden zahlreiche Materialbearbeitungsvorgänge durchgeführt. Beispielsweise ist es üblich, Gläser, Metalle und andere Stoffe mittels Plasmen zu ätzen oder zu beschichten. Insbesondere in der Halbleiterindustrie, wo die äußeren Abmessungen der Bauelemente immer kleiner werden, werden Naßätzungen mehr und mehr von Plasmaätzungen verdrängt, die eine bessere Beseitigung von Silizium oder von polymeren Stoffen ermöglichen.

Die hierfür notwendigen Plasmen können auf verschiedene Weise hergestellt werden. Neben den Gleichspannungsverfahren, bei denen eine Glimmentladung erzeugt wird, werden Wechselspannungsverfahren verwendet, die mit einer Hochfrequenzenergiezuführung arbeiten, die bevorzugt im Bereich von 13,56 MHz betrieben wird.

Bei allen Plasma-Verfahren ist es wichtig, den Einsatz der Plasmabildung festzustellen und die Aufrechterhaltung des Plasmas zu überwachen.

Eine sehr einfache Methode, das Vorliegen eines Plasmas festzustellen, beruht darauf, daß das Licht gemessen wird, das von dem Plasma ausgeht. Je größer die Lichtintensität ist, umso größer ist die Ionisation des Plasmas. Die Nachteile des optischen Verfahrens bestehen darin, daß die Messung durch Fremdlicht beeinflußt werden kann und daß das Meßfenster beim Betrieb der Anlage beschichtet und damit undurchsichtig wird.

Es ist weiterhin bekannt, das Vorhandensein von Plasmen mittels Plasmasonden festzustellen (J. E. Heidenreich III und J. R. Paraszczak: "Electrostatic probe analysis of microwave plasmas used for polymer etching", J. Vac. Sci. Technol. B 5(1), Jan./Feb. 1987, S. 347 bis 354). Der Nachteil derartiger Sonden besteht darin, daß sie direkt ins Plasma eingebracht werden müssen und somit eine Vakuumdurchführung nötig ist. Außerdem ist eine Sonde bei Montage- und Wartungsarbeiten gefährdet oder störend. Hinzu kommt, daß die Lebensdauer einer Plasmasonde begrenzt ist, da diese zum Beispiel zum Sputtern von Dielektrika mitbeschichtet und damit isoliert wird. Durch diese Beschichtung ändern sich die Meßwerte laufend, wodurch quantitative Aussagen problematisch werden.

Außerdem ist ein Verfahren zum Regeln eines Plasma-Ätzprozesses bekannt, bei dem eine Impedanzänderung der Hochfrequenzleistung angezeigt wird (US-A- 4 207 137). Bei diesem Verfahren wird eine ausgewählte Zone auf einer Schicht, die sich über einem Körper befindet, dadurch geätzt, daß der Körper zunächst in einer Kammer und zwischen Elektroden angeordnet wird, daß hierauf ein Gas in die Kammer eingelassen und anschließend elektrische Leistung auf die Elektroden gegeben wird, um Plasma in der Kammer zu erzeugen. Die Impedanzänderung des Plasmas wird während des gesamten Ätzprozesses angezeigt, wobei die elektrische Leistung zu den Elektroden dann abgeschaltet wird, wenn die Impedanzänderung im wesentlich den Wert Null erreicht. Mit Hilfe dieses Verfahrens kann zwar die Beendigung des Ätzprozesses festgestellt werden, es ist jedoch nicht möglich, den Zustand des Plasmas exakt und kontinuierlich zu überwachen. Da nicht jede Konstanz der Impedanz auf eine Beendigung des Ätzprozesses schließen läßt, können bei dem bekannten Verfahren Fehlanzeigen nicht ausgeschlossen werden.

Die wohl bekannteste Methode, das Vorhandensein von Plasmen bei einer Hochfrequenzversorgung festzustellen, besteht darin, daß das Gleichspannungspotential der einspeisenden Elektrode gemessen wird (K. Köhler, J. W. Coburn, D. E. Horne und E. Kay: "Plasma potentials of 13,56-MHz rf argon glow discharges in a planar system", J. Appl. Phys. 57(1), 1 January 1985, S. 59 bis 66). Bei isolierenden Targets ist diese Methode jedoch sehr problematisch, weil sich das Gleichspannungspotential in diesem Fall auf der Targetoberfläche einstellt und diese zum metallischen Elektrodenteil der hochfrequenten Einspeisung galvanisch isoliert ist. In vielen Fällen läßt sich daher kein Gleichstrom von der Elektrode extrahieren, und es ist keine Gleichstromanzeige möglich.

Schließlich ist es auch noch bekannt, die Charakteristiken der Hochfrequenzspannung und des Stroms zu messen sowie die Entstehung der negativen Gleichstromvorspannung bei einer isolierten Elektrode zu erfassen, welche der Oberfläche eines Werkstücks gegenüberliegt, wenn inerte und aktive Gase zugegen sind (R. A. Morgan: Plasma Etching in Semiconductor Fabrication, Verlag Elsevier, Oxford 1985, Seiten 203 bis 239, insbesondere Figuren 8.1 und 8.2 sowie 8.14 bis 8.16). Soweit die negativen Gleichspannungspotentiale der oberen Elektrode gemessen werden, weist dieses bekannte Verfahren dieselben Nachteile wie die vorbeschriebene Methode auf. Bei der Messung des Hochfrequenzpotentials wird ein Oszilloskop verwendet, dessen Spannungsspitzen mit Hilfe eines Sofortfilms fotografiert werden. Dieses Verfahren ist sehr aufwendig. Für die Messung des Hochfrequenzstroms wird eine Scheinelektrode verwendet, welche den Stromfluß über eine geerdete Elektrode simuliert. Dieser Stromfluß wird über einen bekannten Widerstand geschickt, wo eine Spannung entsteht, die ihrerseits wieder auf einem Oszilloskop wiedergegeben wird. Von den auf dem Oszilloskop dargestellten Kurven werden wiederum Fotografien gemacht, was aufwendig und umständlich ist. Eine elektronische Auswertung von Oberwellen, die auf den Fotografien zu sehen sind, erfolgt hierbei nicht.

Der Erfindung liegt die Aufgabe zugrunde, das Vorhandensein von Plasma festzustellen, ohne mit einer Sonde in das Plasma eingreifen zu müssen und ohne auf die Ausbildung einer Gleichstromkomponente an einer Elektrode bzw. auf eine Oszilloskop-Darstellung angewiesen zu sein.

Diese Aufgabe wird gemäß den Merkmalen des Patentanspruchs 1 (Verfahrensanspruch) oder des Patentanspruchs 2 (Vorrichtungsanspruch) gelöst.

Der mit der Erfindung erzielte Vorteil besteht insbesondere darin, daß nur die dem Plasma zugeführte elektrische Hochfrequenzenergie ausgewertet wird, um zu einer Entscheidung zu gelangen, ob ein Plasma vorliegt oder nicht. Das Plasma selbst wird weder optisch betrachtet noch elektrisch analysiert. Der erfindungsgemäßen Methode liegt der anerkannte Sachverhalt zugrunde, daß ein Hochfrequenz-Plasma eine nichtlineare Impedanz darstellt, die Oberwellen erzeugt. Da diese Oberwellen nur auftreten, wenn ein Plasma vorliegt, können sie zur Plasmaerkennung verwendet werden.

Besondere Ausführungsarten der Erfindung sind in den abhängigen Ansprüchen angegeben.

Ein Ausführungsbeispiel der Erfindung ist in der Zeichnung dargestellt und wird im folgenden näher beschrieben. Es zeigen:
- Fig. 1: eine Prinzipdarstellung der erfindungsgemäßen Schaltungsanordnung zum Erkennen eines Plasmas;
- Fig. 2: eine Filter- und Gleichrichterschaltung, mit welcher Oberwellen ausgesiebt und verarbeitet werden.

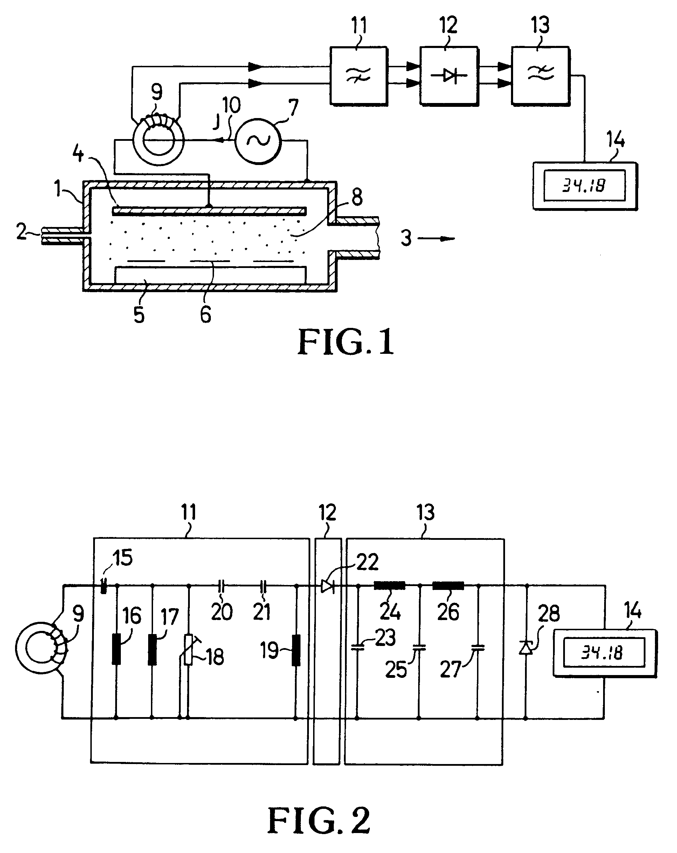

In der Fig. 1 ist das Prinzip einer Einrichtung dargestellt, mit der zum Beispiel dünne Filme abgeschieden werden können und die eine erfindungsgemäße Plasmaerfassung aufweist. Diese Einrichtung weist eine Kammer 1 auf, in der sich eine Probe befindet, ferner ein Gaseinführungssystem 2 und ein Gasabführungssystem 3. Außerdem ist eine Hochfrequenzelektrode 4 vorgesehen, die ein Plasma erzeugt und die einem Probentisch 5 gegenüberliegt, der sich in der Kammer 1 befindet. Eine Hochfrequenzleistung gelangt aus einer Hochfrequenz-Stromversorgung 7 auf die Elektrode 4, wodurch ein Plasma 8 entsteht, sofern Druckverhältnisse von etwa 10⁻⁴ bis 10 Torr vorliegen. Aufgrund dieses Plasmas 8 schlägt sich ein dünner Film auf einem Substrat 6 nieder, das auf dem Probentisch 5 angeordnet ist. Die Hochfrequenz, die von der Elektrode 4 ausgeht und bei der es sich vorzugsweise um eine Frequenz fₒ von 13,56 MHz handelt, dissoziiert das in der Kammer 1 befindliche Gas und erzeugt auf diese Weise Plasma.

Um festzustellen, ob ein Plasma vorliegt oder ob sich das Gas noch in nicht-dissoziiertem Zustand befindet, ist eine Induktive Stromaufnahme vorgesehen, die den auf die Elektrode 4 fließenden Strom J erfaßt. Diese Stromaufnahme besteht beispielsweise aus einer toroidförmigen Spule (9) (vgl. US-A- 4 493 112, Fig. 3), die um die Zuführungsleitung 10 gelegt ist, die zwischen der Stromversorgung 7 und der Elektrode 4 verläuft. Diese Spule 9 kann statt mehrerer Windungen auch nur eine Windung aufweisen. Durch das magnetische Feld, welches der Strom J um die Zuführungsleitung herum erzeugt, wird in der Spule 9 eine Spannung induziert, die auf einen Hochpaß 11 gelangt. Dieser Hochpaß 11 filtert alle Frequenzen heraus, die kleiner als 20 MHz sind. Hierdurch werden alle Gleichstromanteile des Stroms J sowie seine Grundfrequenz von 13,56 MHz unterdrückt. Durchgelassen werden nur noch Oberwellen, die dann entstehen, wenn ein Plasma vorliegt. Ist kein Plasma vorhanden, so stellt die Elektrode 4 eine Reaktanz dar. Da die Hochfrequenz-Stromversorgung 7 ein sinusförmiges Signal abgibt, ist der Strom J in diesem Fall rein sinusförmig. Es treten somit keine anderen Frequenzen als 13,56 MHz auf. Am Ausgang des Hochpasses 11 steht folglich nur dann ein Signal an, wenn ein Plasma erzeugt wurde, weil dieses für die Oberwellen verantwortlich ist. Hat ein Plasma gezündet, so weist die Elektrode 4 aufgrund der unterschiedlichen Masse von Elektronen und Ionen eine nichtlineare Impedanz auf. Durch diese Nichtlinearität entstehen Mischprodukte, die insbesondere die Frequenzen der Harmonischen (27,12 MHz; 40,68 MHz etc.) enthalten. Das Ausgangssignal des Hochpasses 11 wird durch einen Gleichrichter 12 gleichgerichtet und auf einen Tiefpaß 13 gegeben. Dieser Tiefpaß 13 hat lediglich die Aufgabe, die noch vorhandene Restwelligkeit der am Ausgang des Gleichrichters 12 anstehenden Gleichspannung zu beseitigen oder wenigstens zu vermindern. Die auf diese Weise geglättete Gleichrichtung wird einer Anzeigevorrichtung 14 zugeführt, welche eine Größe anzeigt, die ein Maß für die Oberwellen jenseits der 13,56 MHz und damit ein Maß für die Ausbildung des Plasmas ist.

In der Fig. 2 sind die in der Fig. 1 gezeigten Filter noch einmal näher dargestellt. Man erkennt hierbei, daß das Hochpaßfilter 11 einen Serienkondensator 15 enthält, dem zwei Parallelinduktivitäten 16, 17 nachgeschaltet sind. Parallel zu diesen Induktivitäten 16, 17 liegt ein regelbarer Widerstand 18 geschaltet, auf den im Längszweig des Hochpaßfilters 11 zwei hintereinander geschaltete Kondensatoren 20, 21 folgen, die von einer Parallelinduktivität 19 abgeschlossen werden. Das Ausgangssignal des Hochpaßfilters 11 wird mittels einer Diode 22 gleichgerichtet. Da es sich hierbei um eine Halbweggleichrichtung handelt, ist die Restwelligkeit des gleichgerichteten Signals noch relativ hoch. Diese Restwelligkeit wird durch das nachgeschaltete Tiefpaßfilter 13 verringert, das einen Kondensator 23 im Querzweig, daran anschließend eine Induktivität 24 im Längszweig, hieran anschließend einen weiteren Kondensator 25 im Querzweig, darauf folgend eine weitere Induktivität 26 im Längszweig und schließlich einen Kondensator 27 im Querzweig enthält. An den Ausgang des Tiefpaßfilters 13 ist eine Zenerdiode 28 gelegt, welche verhindert, daß der Anzeige 14 zu große Spannungen zugeführt werden.

Bei der Hochfrequenz-Stromversorgung 7 handelt es sich um eine Energiequelle, die im Frequenzbereich von etwa 100 kHz bis 1 GHz arbeitet. Dieser Frequenzbereich wird deshalb bevorzugt, weil bei üblichen Anlagengrößen nur in diesem Frequenzbereich die unterschiedlichen freien Weglängen von Elektronen und Ionen entstehen, die für die Nichtlinearität des Plasmas verantwortlich sind.

Die in den Fig. 1 und 2 dargestellten Anordnungen können nicht nur verwendet werden, um zu erkennen, ob ein Plasma vorhanden ist oder nicht, sondern sie liefern auch ein quantitatives Signal, das eine Aussage über die Ionisierung und die Leistung des Plasmas zuläßt. Beispielsweise könnten zwei synchron sputternde Elektroden auf gleiche Leistung eingestellt werden. Hierfür würde das Ausgangssignal des Tiefpasses 13 nicht einer Anzeige 14, sondern einem nicht dargestellten Anlagensteuerrechner zugeführt und zur Kontrolle des Prozeßablaufs in diesem ausgewertet. Die Anzeige erfolgt dann auf einem Monitor des Rechners.

Die Stromerfassung mittels einer Toroidspule ist zwar sehr zweckmäßig, doch ist die Erfindung nicht hierauf beschränkt. Der Strom könnte ebensogut mittels ohmscher oder kapazitiver Spannungsleiter erfaßt werden.

Die Erfindung ist ebenfalls nicht auf die Einspeisung eines reinen Wechselstroms J mit der Frequenz fₒ beschränkt. Sie kann auch dann Verwendung finden, wenn ein mit einem Wechselstrom modulierter Gleichstrom auf die Elektrode 4 gegeben wird.

## Patentansprüche

1. Verfahren zum Erkennen eines Plasmas, das sich in einem mit einer Elektrode (4) versehenen Behälter (1) befindet, **gekennzeichnet durch** folgende Schritte:
a) es wird eine hochfrequente Wechselspannung mit einer Frequenz (fₒ) an der Elektrode (4) in dem Behälter (1) angelegt;
b) es wird ein hochfrequenter Wechselstrom (J) mit der Frequenz (fₒ) im Plasma erzeugt, dem höhere Frequenzen von durch das Plasma erzeugte Oberwellen beigemischt sind;
c) der hochfrequente Wechselstrom (J) wird mittels einer Schaltungsanordnung erfaßt;
d) der erfaßte Wechselstrom (J) wird einem Hochpaßfilter (11) zugeführt, welches Frequenzen durchläßt, die oberhalb der vorgegebenen Frequenz (fₒ) liegen;
e) es wird eine Größe dargestellt, welche ein Maß für die Oberwellen jenseits fₒ ist.

2. Mittel zum Erkennen eines Plasmas in einem Behälter (1), das durch eine hochfrequente Wechselspannungsquelle (7) von vorgegebener Frequenz (fₒ) erzeugt wird, **gekennzeichnet durch**
a) eine Elektrode (4) in dem Behälter (1), die an die Wechselspannungsquelle (7) angeschlossen ist;
b) eine Einrichtung (9) zum Erfassen des zwischen der Wechselspannungsquelle (7) und der Elektrode (4) fließenden hochfrequenten Wechselstroms (J);
c) ein mit der Einrichtung (9) verbundenes Hochpaßfilter (11), das Frequenzen durchläßt, die oberhalb einer vorgegebenen Frequenz (fₒ) liegen;
d) eine Auswerteeinrichtung (12, 13), die mit dem Hochpaßfilter (11) verbunden ist und die Ausgangssignale des Hochpaßfilters (11) auswertet.

3. Mittel nach Anspruch 2, **dadurch gekennzeichnet**, daß das Ausgangssignal des Hochpaßfilters (11) einem Gleichrichter (12) zugeführt und das Ausgangssignal des Gleichrichters (12) auf eine Anzeigevorrichtung (14) gegeben ist.

4. Mittel nach Anspruch 2, **dadurch gekennzeichnet**, daß zwischen dem Gleichrichter (12) und der Anzeigevorrichtung (14) ein Tiefpaßfilter (13) geschaltet ist.

5. Mittel nach Anspruch 2, **dadurch gekennzeichnet**, daß die Anzeigevorrichtung (14) ein analoges Anzeigegerät ist.

6. Mittel nach Anspruch 2, **dadurch gekennzeichnet**, daß die Anzeigevorrichtung (14) ein digitales Anzeigegerät ist.

7. Mittel nach Anspruch 2, **dadurch gekennzeichnet**, daß eine Induktivität (9) vorgesehen ist, die den Wechselstrom (J) erfaßt und dem Hochpaßfilter (11) zuführt.

8. Mittel nach Anspruch 2, **dadurch gekennzeichnet**, daß der hochfrequente Wechselstrom eine Frequenz von 13,56 MHz hat.

9. Mittel nach Anspruch 2, **dadurch gekennzeichnet**, daß das Hochpaßfilter (11) von seinem Eingang in Richtung auf seinen Ausgang im ersten Längszweig einen Kondensator (15) aufweist, auf den im ersten Querzweig zwei Induktivitäten (16, 17) und ein regelbarer Widerstand (18) folgen, daß auf die Elemente des ersten Querzweigs zwei Kondensatoren (20, 21) in einem zweiten Längszweig folgen und daß das Hochpaßfilter (1) durch eine Induktivität (19) in einem zweiten Querzweig abgeschlossen ist.

10. Mittel nach Anspruch 2, **dadurch gekennzeichnet**, daß der Gleichrichter (12) ein Einweggleichrichter ist.

11. Mittel nach Anspruch 2, **dadurch gekennzeichnet**, daß das Tiefpaßfilter (13) von seinem Eingang in Richtung auf seinen Ausgang in einem ersten Querzweig einen ersten Kondensator (23), in einem ersten Längszweig eine Induktivität (24), in einem zweiten Querzweig einen Kondensator (25), in einem zweiten Längszweig eine zweite Induktivität (26) und in einem dritten Querzweig einen dritten Kondensator (27) aufweist.

12. Mittel nach Anspruch 2, **dadurch gekennzeichnet**, daß dem Ausgang des Tiefpaßfilters (13) eine Zenerdiode (28) parallelgeschaltet ist.

## Claims

1. Process for determining the presence of a plasma which is located in a container (1) provided with an electrode (4), characterized by the following steps:
a) a high-frequency alternating voltage having a frequency (fₒ) is applied to the electrode (4) in the container (1);
b) a high-frequency alternating current (J) having the frequency (fₒ) is generated in the plasma, higher frequencies of harmonic waves produced by the plasma being mixed in with it;
c) the high-frequency alternating current (J) is detected by means of a circuit arrangement;
d) the detected alternating current (J) is supplied to a high-pass filter (11) which allows through frequencies which are above the predetermined frequency (fₒ);
e) a variable which is a measure of the harmonic waves beyond fₒ is displayed.

2. Means of determining the presence of a plasma in a container (1), this plasma being generated by a high-frequency alternating voltage source (7) of predetermined frequency (fₒ), characterized by
a) an electrode (4) in the container (1), this electrode being connected to the alternating voltage source (7);
b) a device (9) for detecting the high-frequency alternating current (J) which flows between the alternating voltage source (7) and the electrode (4);
c) a high-pass filter (11) which is connected to the device (9) and which allows through frequencies which are above a predetermined frequency (fₒ);
d) an evaluating device (12, 13) which is connected to the high-pass filter (11) and which evaluates the output signals of the high-pass filter (11).

3. Means according to Claim 2, characterized in that the output signal of the high-pass filter (11) is supplied to a rectifier (12) and the output signal of the rectifier (12) is passed to a display apparatus (14).

4. Means according to Claim 2, characterized in that a low-pass filter (13) is connected between the rectifier (12) and the display apparatus (14).

5. Means according to Claim 2, characterized in that the display apparatus (14) is an analog display device.

6. Means according to Claim 2, characterized in that the display apparatus (14) is a digital display device.

7. Means according to Claim 2, characterized in that an inductor (9) which detects the alternating current (J) and supplies it to the high-pass filter (11) is provided.

8. Means according to Claim 2, characterized in that the high-frequency alternating current has a frequency of 13.56 MHz.

9. Means according to Claim 2, characterized in that the high-pass filter (11) has, from its input in the direction of its output, in the first lengthwise branch a capacitor (15) which is followed in the first crosswise branch by two inductors (16, 17) and a regulable resistor (18), in that the elements of the first crosswise branch are followed in a second lengthwise branch by two capacitors (20, 21), and in that the high-pass filter (1) is terminated in a second crosswise branch by an inductor (19).

10. Means according to Claim 2, characterized in that the rectifier (12) is a one-way rectifier.

11. Means according to Claim 2, characterized in that the low-pass filter (13) has, from its input in the direction of its output, in a first crosswise branch a first capacitor (23), in a first lengthwise branch an inductor (24), in a second crosswise branch a capacitor (25), in a second lengthwise branch a second inductor (26) and in a third crosswise branch a third capacitor (27).

12. Means according to Claim 2, characterized in that a Zener diode (28) is connected in parallel with the output of the low-pass filter (13).

## Revendications

1. Procédé de détection d'un plasma se trouvant à l'intérieur d'un récipient (1) pourvu d'une électrode (4), caractérisé par les étapes suivantes :
a) une tension alternative à haute fréquence, d'une fréquence (fₒ), est appliquée sur l'électrode (4) située dans le récipient (1) ;
b) un courant alternatif à haute fréquence (J), de la fréquence (fₒ), est produit dans le plasma, auquel se mêlent des fréquences plus élevées d'ondes harmoniques produites par le plasma ;
c) le courant alternatif à haute fréquence (J) est capté par un montage électrique ;
d) le courant alternatif (J) capté est acheminé vers un filtre passe-haut (11), qui laisse passer les fréquences qui sont supérieures à la fréquence prédéterminée (fₒ) ;
e) on obtient une valeur représentant une mesure des ondes harmoniques au-delà de fₒ.

2. Moyens de détection d'un plasma à l'intérieur d'un récipient (1), produit par une source de tension alternative à haute fréquence (7) de fréquence prédéterminée (fₒ), caractérisés par
a) une électrode (4) située dans le récipient (1), qui est raccordée à la source de tension alternative (7) ;
b) un dispositif (9) de détection du courant alternatif à haute fréquence (J) circulant entre la source de tension alternative (7) et l'électrode (4) ;
c) un filtre passe-haut (11), relié au dispositif (9), laissant passer les fréquences supérieures à une fréquence prédéterminée (fₒ) ;
d) un dispositif de traitement (12, 13) relié au filtre passe-haut (11) et traitant les signaux de sortie du filtre passe-haut (11).

3. Moyens selon la revendication 2, caractérisés en ce que le signal de sortie du filtre passe-haut (11) est acheminé vers un redresseur (12) et le signal de sortie du redresseur (12) est envoyé à un dispositif d'affichage (14).

4. Moyens selon la revendication 2, caractérisés en ce qu'un filtre passe-bas (13) est monté entre le redresseur (12) et le dispositif d'affichage (14).

5. Moyens selon la revendication 2, caractérisés en ce que le dispositif d'affichage (14) est un afficheur analogique.

6. Moyens selon la revendication 2, caractérisés en ce que le dispositif d'affichage (14) est un afficheur numérique.

7. Moyens selon la revendication 2, caractérisés en ce qu'une inductance (9) est prévue, qui capte le courant alternatif (J) et le conduit vers le filtre passe-haut (11).

8. Moyens selon la revendication 2, caractérisés en ce que le courant alternatif à haute fréquence présente une fréquence de 13,56 MHz.

9. Moyens selon la revendication 2, caractérisés en ce que le filtre passe-haut (11), de son entrée vers sa sortie, présente, dans la première branche longitudinale, un condensateur (15), auquel font suite, dans la première branche transversale, deux inductances (16, 17) et une résistance réglable (18), en ce que deux condensateurs (20, 21) font suite, dans une deuxième branche longitudinale, aux éléments de la première branche transversale, et en ce que le filtre passe-haut (11) se termine par une inductance (19) située dans une deuxième branche transversale.

10. Moyens selon la revendication 2, caractérisés en ce que le redresseur (12) est un redresseur demi-onde.

11. Moyens selon la revendication 2, caractérisés en ce que le filtre passe-bas (13), de son entrée vers sa sortie, présente, dans une première branche transversale, un premier condensateur (23), une inductance (24) dans une première branche longitudinale, un condensateur (25) dans une deuxième branche transversale, une deuxième inductance (26) dans une deuxième branche longitudinale et un troisième condensateur (27) dans une troisième branche transversale.

12. Moyens selon la revendication 2, caractérisés en ce qu'une diode Zener (28) est montée en parallèle à la sortie du filtre passe-bas (13).
